(19) Europäisches Patentamt
European Patent Office
Office européen des brevets

(11) **EP 2 354 800 A1**

(12) **EUROPEAN PATENT APPLICATION**

(43) Date of publication:
**10.08.2011 Bulletin 2011/32**

(51) Int Cl.:
**G01R 19/25** (2006.01)

(21) Application number: **10152247.2**

(22) Date of filing: **01.02.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **ABB Research Ltd**
**8050 Zürich (CH)**

(72) Inventors:
• **Escobar, Gerardo**
  **8050 Zürich (CH)**
• **Serpa, Leonardo-Augusto**
  **8050 Zürich (CH)**

• **Paakkinen, Mikko**
  **8050 Zürich (CH)**
• **Coccia, Antonio**
  **8050 Zürich (CH)**
• **Pettersson, Sami**
  **8050 Zürich (CH)**

(74) Representative: **Valkeiskangas, Tapio Lassi**
**Paavali**
**Kolster Oy Ab**
**Iso Roobertinkatu 23**
**P.O. Box 148**
**00121 Helsinki (FI)**

(54) **Method of and apparatus for determining fundamental frequency component of the grid voltage**

(57)    A method and arrangement of estimating the fundamental frequency component of the grid voltage $(\hat{v}_{S,1})$ of a single phase network. The method comprises the steps of measuring the grid voltage $(v_S)$ of the single phase network, forming an adaptive estimator (AQSG) having a parameter $(\hat{\Omega})$ having the information on the fundamental frequency $(\omega_0)$ of the grid voltage, the adaptive estimator producing an estimate of the fundamental frequency component of the grid voltage, forming an adaptation law (FFE) receiving parameters from the adaptive estimator (AQSG) for producing an estimate for the parameter $(\hat{\Omega})$ having the information on the fundamental frequency of the grid voltage, feeding the estimated value for the parameter $(\hat{\Omega})$ having the information of the fundamental frequency to the adaptive estimator from the adaptation law to be used in the estimation of the fundamental frequency component of the grid voltage $(\hat{v}_{S,1})$.

FIG 1

EP 2 354 800 A1

## EP 2 354 800 A1

**Description**

FIELD OF THE INVENTION

The present invention relates to a method of determining the fundamental frequency component of the grid voltage and to an apparatus for carrying out the determination. Particularly the invention relates to a method and apparatus with which the fundamental frequency component of the grid voltage can be determined for synchronizing an electrical device with the grid.

BACKGROUND OF THE INVENTION

It is known that an important aspect in the control of single phase grid connected power converters is the detection of the fundamental frequency component of the utility voltage. Specifically, in single phase systems, the detection of this signal is essential for the control of distributed generation and storage systems, flexible AC systems (FACTS), power line conditioners, unin-terruptible power supplies (UPS), grid connected inverters for alternative source energies (photovoltaic, windpower sources, etc), and other grid connected power conditioning equipment.

It is also known that for control design purposes the above systems require a reference signal, which must be, in general, a pure sinusoidal signal in phase with the fundamental component of the grid voltage signal. This signal can be used to build the reference for the current in a current controller, or as the basis for transformation to rotating frame coordinates. Therefore it is important to design a system that provides a signal of the highest quality as accurately and as fast as possible, despite of the existence of disturbances in grid voltage, such as frequency variations, harmonic distortion, sags, and swells, among other grid faults.

The most widely accepted solution to provide information about the fundamental component of the grid voltage, which is somehow insensitive to frequency variations, consists of the use of phase locked loop (PLL) schemes [1]. Most PLLs deliver the fundamental component of the utility voltage (or a scaled or normalized version of it) plus an estimation of the phase angle and/or the fundamental frequency. The original schemes of PLLs were designed very intuitively and were composed mainly of a phase detector, a filter, and a voltage controlled oscillator (VCO).

One of the most appealing PLL schemes was presented in the seminal paper [2]. In this scheme the three-phase grid voltage signals are transformed to rotating frame coordinates. The d-component (or q-component, depending on the transformation used) is then regulated to a certain reference by means of a proportional integral (PI) control, out of which the frequency is obtained. This estimated frequency is then integrated to reconstruct the phase angle, which is used in the previous rotating frame transformation.

The integral action in the PI control stops at the point where the rotating frame is synchronized with the grid voltage vector described in fixed frame coordinates. This scheme has shown good results at least in the cases where harmonic distortion or unbalance is not present. This scheme was referred to as the SRF-PLL, as it was based on the synchronous frame representation of the grid voltage vector signal.

The above idea has been extended to the single phase case. For this purpose it is usually proposed to emulate a balanced three-phase system where the $\alpha$-component is represented by the single-phase grid voltage, and the $\beta$-component, i.e. the quadrature companion signal, is synthesized using many different approaches [3]-[9]. Roughly speaking, these two signals form a virtual utility voltage vector in the fixed frame representation, to which the same ideas of SRF-PLL could be directly applied [3].

Different schemes have been proposed based on this simple scheme, where the main contributions are in the design of such a quadrature-signals generator (QSG) as pointed out before. In [4] and [5] the conventional schemes based on the previously described concepts have been deeply studied, namely inverse Park transformation PLL (Park-PLL) [5], [3], enhanced PLL (EPLL) [6], [7], power-base PLL (pPLL) [8], Hilbert transformer-based PLL [9], and transport delay-based PLL [5].

However, it has been observed that most of these solutions are very sensitive to harmonic distortion [5], and they may also suffer during unbalance operation in the three phase case [2]. Moreover, in the single phase case, it is very likely that an unavoidable fluctuation of a second order harmonic arises in the feedback or internal control signals. To alleviate these issues, it is common in practice to simply limit the bandwidth of the PLL scheme, which, in turn, leads to very poor performance, as the speed of the response is considerably reduced. Some works have tried to overcome these issues by adding very intuitive modifications [3]. For instance, [10] teaches to add a repetitive scheme based in a FIR filter to somehow compensate for the harmonic distortion in the feedback signal used in a conventional SRF-PLL, i.e. [10] teaches to eliminate the harmonics to the d-component of the grid voltage error prior to feeding the PI controller. The main drawback in this scheme is that the repetitive scheme requires the knowledge of the fundamental frequency, and thus this scheme may be non-robust with respect to uncertainties in such a parameter.

In [11] a scheme based on a second order generalized integrator (SOGI) carrying out the function of a QSG is presented. The QSG gives an estimate of the fundamental component of the grid voltage signal and its quadrature companion. Then, on the basis of these signals, [11] teaches to simply use the conventional SRF-PLL to estimate the fundamental frequency. For the three-phase case, the QSG is simply duplicated, one for each coordinate in the fixed frame ($\alpha\beta$-coordinates). Evidently this solution inherits the same issues as in SRF-PLL. Moreover, since the QSG requires the knowledge of the fundamental frequency, then the document proposes to simply feedback the estimated frequency (out of the SRF-PLL) to the QSG without any further consideration. However, this feedback may produce stability issues that have not been addressed so far.

It is important to highlight the fact that all the previous schemes are based on the simple assumption that sin ($x$)=$x$, which holds for $x$ sufficiently small only. That is, they are somehow based on a process of linearization, and thus the results can only be of a local nature, which somehow restricts their range of operation. Moreover, many of the original schemes are based on the detection of the phase angle, which gives a good intuitive understanding of the operation. However, as already noticed in several documents, schemes following this philosophy present severe stability issues under utility fault conditions [4]-[5].

Documents [12]-[13] extend the above scheme [11], where the SRF-PLL is changed by a scheme that directly reconstructs the fundamental frequency. This latter is referred to as frequency-locked loop (FLL) by the authors. The same QSG scheme as before is used to estimate the quadrature signals, i.e. the fundamental component of the grid voltage and its quadrature companion. Then, for the three-phase case, the documents teach to use only the $\beta$-component for the estimation of the fundamental frequency, without any further detail on this decision. However, this scheme may experience convergence problems in cases where, for some reason, such a $\beta$-component becomes arbitrarily small. As in the previous scheme, the estimated fundamental frequency is feedback to the QSG without any further study of stability or convergence.

BRIEF DESCRIPTION OF THE INVENTION

An object of the present invention is to provide a method and an arrangement for implementing the method so as to alleviate the above disadvantages. The objects of the invention are achieved by a method and an arrangement which are characterized by what is stated in the independent claims. The preferred embodiments of the invention are disclosed in the dependent claims.

The invention is based on the idea of using an adaptive estimator together with an adaptation scheme for estimating the fundamental component of the grid voltage. The adaptive estimator produces the fundamental voltage component and not the phase angle of the voltage, which enhances the stability of the estimation. The estimation of the fundamental voltage component is advantageous especially in cases where the fundamental frequency is uncertain or may experience variations.

In a preferred embodiment also the quadrature companion signal of the fundamental component is estimated.

In another preferred embodiment also the harmonic components of the grid voltage are taken into account, which yields a more precise estimate of the fundamental component of the grid voltage in a highly polluted network.

The invention is typically implemented in an apparatus that is to be synchronized with the network. Since the estimate of the voltage of a single phase network is accurate, fluent synchronization to the network is possible.

The overall design of the method is based on a dynamic model of the generator of a sinusoidal signal, which is in fact a second order harmonic oscillator (SOHO). This allows the use of additional information, such as the dynamic structure for the PLL design, which leads to more effective algorithms.

The quadrature signal generator of the embodiments arises in a natural way from the model description of the system. Previous techniques struggle to find this QSG by following different techniques that require additional phase shift compensation in many cases. In the present invention, the adaptive quadrature signal generator (AQSG) or the version with harmonics compensation (AQSG-H) in the embodiments delivers the quadrature signals with corresponding zero phase shifts.

The method does not depend on the usual linearization assumption, that is, it is not based on the assumption *sin x = x* for an arbitrarily small *x* . Therefore, the applicability of the method is not limited to a local operation region.

The method directly estimates the fundamental frequency instead of the phase angle. In fact, the phase angle is not required at all but can be reconstructed, if necessary. It is well known that the estimation of the phase angle shows more stability issues.

Further, the method is global in the sense that no matter what amplitude, frequency or phase shift is considered, the convergence and stability is guaranteed at all times.

An embodiment of the method includes a harmonics compensation mechanism explicitly designed for the harmonics cancellation. Therefore, this embodiment is able to deliver much cleaner responses in spite of the existence of highly harmonic distortion in the grid voltage.

The design of an embodiment considers the model of a periodic distorted signal conformed by harmonic components, i.e. a more complete model of the generator of the grid voltage signal, which includes the generators of higher order harmonic components, i.e. a sum of SOHO tuned at the fundamental frequency and at higher harmonics.

BRIEF DESCRIPTION OF THE DRAWINGS

In the following, the invention will be described in greater detail by means of preferred embodiments with reference to the attached drawings, in which

Figure 1 is a block diagram of the adaptive quadratic-signals generator (AQSG);
Figure 2 is a block diagram of the fundamental frequency estimator (FFE);
Figure 3 is a block diagram of the quadrature-companion generator (QCG);
Figure 4 is a block diagram of an embodiment of the invention;
Figure 5 shows voltage waveforms in connection with the method;
Figure 6 shows voltage waveforms in connection with transients in the grid voltage;
Figure 7 shows transient behavior of the estimated fundamental frequency;
Figure 8 shows frequency responses of the method;
Figure 9 shows an embodiment of Figure 1;
Figure 10 shows an embodiment of Figure 2;
Figure 11 shows an embodiment of Figure 3;
Figure 12 shows voltage waveforms in connection with the method;
Figure 13 shows voltage waveforms in connection with transients in the grid voltage;
Figure 14 shows transient behavior of the estimated fundamental frequency; and
Figure 15 shows frequency responses of an embodiment.

DETAILED DESCRIPTION OF THE INVENTION

In the following, the design of an adaptive quadrature signals generator forming a phase locked loop (referred to as AQSG-PLL) used in the method is described in detail.

Considering that the grid voltage is mainly composed of a fundamental component, i.e. the higher harmonics are negligible, and that the dynamical model that generates such a component is the following second order harmonic oscillator (SOHO)

$$\dot{v}_S = \omega_0 \varphi \quad , \quad v_S(0) = v_{S,0}$$
$$\dot{\varphi} = -\omega_0 v_S \quad , \quad \varphi(0) = \varphi_0 \tag{1}$$

where $\omega = \omega_0$ represents the fundamental frequency, $v_s$ is the grid voltage, $\varphi$ is the quadrature companion signal, and $v_{S,0}, \varphi_0$, are the initial conditions.

It is to be noted that the fundamental frequency parameter $\omega_0$ appears in both rows of the model (1), which may complicate the design of the adaptive algorithm to reconstruct it. To overcome this issue, the model is changed by using the following transformation

$$\psi = \varpi_0 \frac{\varphi}{\omega_0} \tag{2}$$

where $\varpi_0$ represents a nominal value of the fundamental frequency, i.e. a positive constant parameter which can be simply an approximate known a priori.

Out of this, the system is transformed to

$$\dot{v}_S = \frac{\omega_0^2}{\varpi_0} \psi$$
$$\dot{\psi} = -\varpi_0 v_S \tag{3}$$

By defining a new parameter

$$\Omega = \frac{\omega_0^2}{\varpi_0} \qquad (4)$$

the model that describes the generator of signal $v_s$ can be rewritten as

$$\begin{aligned} \dot{v}_S &= \Omega \psi \\ \dot{\psi} &= -\varpi_0 v_S \end{aligned} \qquad (5)$$

It is to be noted that after this simple transformation, the fundamental frequency parameter $\omega_0$ has been concentrated, in the form of a function, in one single unknown parameter $\Omega$, which represents the scaled square of the fundamental frequency and has also units of frequency, i.e. rad/s. Notice that the new variable $\Psi$ is still a signal in quadrature to $v_s$ and, thus the system (5) is still a SOHO.

On the basis of this new model description, an estimator is designed for the fundamental component of the state variable $v_s$ and, in addition, an adaptive law must be provided to reconstruct the unknown parameter $\Omega$. That is, out of this adaptive estimator, the fundamental component of the grid voltage and an estimate for the fundamental frequency can be obtained.

The adaptive estimator of the method, which is referred to as the adaptive quadratic signals generator (AQSG), consists of a copy of the system model (5) to which a damping term is added, that is,

$$\begin{aligned} \dot{\hat{v}}_{S,1} &= \hat{\Omega} \hat{\psi}_1 + \gamma_1 \tilde{v}_S \\ \dot{\hat{\psi}}_1 &= -\varpi_0 \hat{v}_{S,1} \end{aligned} \qquad (6)$$

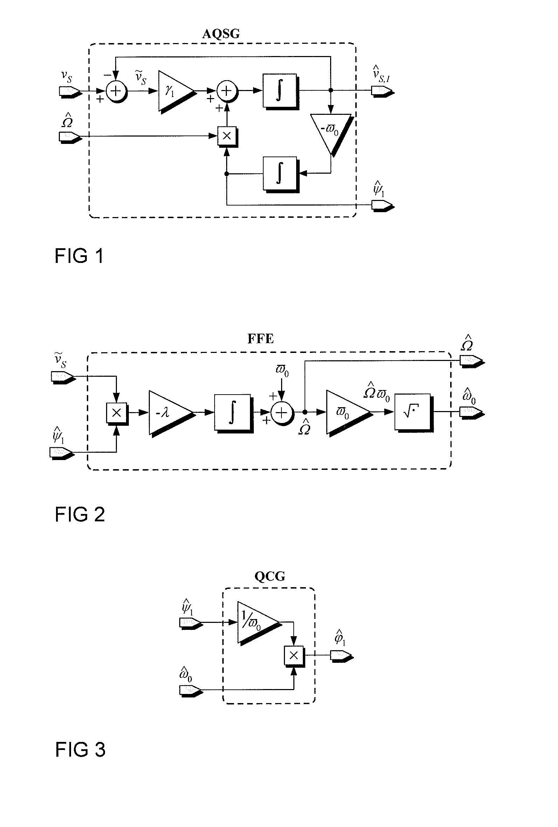

where $\tilde{v}_s = v_s - \hat{v}_{s,1}$ ; $\hat{v}_{s,1}$ and $\hat{\Psi}_1$ represent the estimates of $v_s$ and $\Psi$, respectively; $\hat{\Omega}$ is the estimate of the parameter $\Omega$ ; and $\gamma_1 > 0$ is a design parameter used here to introduce the required damping to achieve convergence with stability. A block diagram of the AQSG is presented in Figure 1. AQSG receives as inputs the measured voltage of the grid $v_s$ and an estimate of the parameter $\hat{\Omega}$ . Further, as is also clear from (6), the block diagram of Figure 1 outputs an estimate of the fundamental component of the grid voltage $\hat{v}_{s,1}$ and the defined parameter $\hat{\Psi}_1$ in which the subscript 1 refers to fundamental frequency.

The adaptive law to reconstruct $\hat{\Omega}$ involved in equation (6) is referred to as the fundamental frequency estimator (FFE)

$$\begin{aligned} \dot{\hat{\Omega}} &= \lambda \hat{\psi}_1 \tilde{v}_S \\ \hat{\omega}_0 &= \sqrt{\varpi_0 \hat{\Omega}} \end{aligned} \qquad (7)$$

where $\lambda > 0$ is referred to as the adaptation gain. The above adaptive law is obtained using basic principles of the adaptation theory [14].

A block diagram of the fundamental frequency estimator is presented in Figure 2. The block diagram of Figure 2 includes a feedforward term $\varpi_0$ summed to the output of the integrator block to allow a softer start-up operation. The block diagram of Figure 2 receives as inputs the difference $\tilde{v}_s$ between the measured grid voltage and the estimated fundamental voltage component and the estimated value of $\hat{\Psi}_1$ The output of the FFE block diagram is an estimate of the unknown parameter $\hat{\Omega}$ and an estimate of the fundamental frequency $\hat{\omega}_0$

According to an embodiment of the invention, an estimate of the fundamental component of the quadrature companion signal φ is reconstructed according to (2) as follows:

$$\hat{\varphi}_1 = \hat{\omega}_0 \frac{\hat{\psi}_1}{\varpi_0} \qquad (8)$$

Equation (8) is referred to as the quadrature companion generator (QCG) and its block diagram is presented in Figure 3.

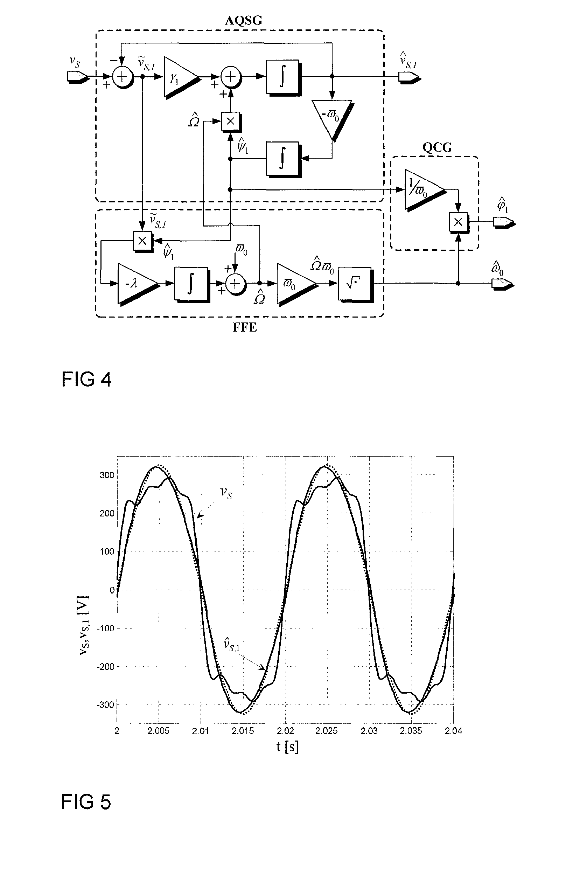

By combining the above equations relating to the above described block diagrams, the block diagram of Figure 4 is obtained. Thus the AQSG-PLL consists of the AQSG (equation (6)) and the FFE (equation (7)). In an embodiment AQSG-PLL also comprises the QCG of equation (8).

Figure 4 also includes equation (8) (QCG). It is to be noted, however, that the quadrature companion component $\hat{\varphi}_1$, obtained with QCG does not have to be calculated if it is not needed for some purposes. Specifically Figure 4 shows how, based on the measured grid voltage $v_s$ , the estimate of the fundamental component $\hat{v}_{s,1}$ of the grid voltage is obtained. The difference $\tilde{v}_{s,1}$ between the measured grid voltage and the estimated fundamental component of the grid voltage is fed from AQSG to FFE together with the estimated value of $\hat{\Psi}_1$ The FFE block calculates from these estimates an estimate $\hat{\Omega}$ for the unknown parameter and outputs this estimate to the AQSG block, in which the estimate is used in estimation of the fundamental component of the grid voltage.

As mentioned above, block QSG used for estimation of the quadrature companion of the voltage is not necessary for the method if the quadrature companion is not needed. As shown in Figure 4, the FFE block also produces an estimated fundamental frequency of the grid voltage. The fundamental frequency is calculated directly from the unknown parameter $\hat{\Omega}$ by multiplying it with the nominal value of the fundamental frequency $\varpi_0$ , and by taking a square root from the multiplication result, as is also clear from equation (4).

A first tuning of this scheme, based on a linearization of the presented AQSG-PLL, yields the following rule of thumb:

$$\gamma_1 = 2\omega_{BW}$$
$$\lambda = \frac{\omega_{BW}^2}{V_S^2} \qquad (9)$$

where $\omega_{BW}$ is the desired bandwidth of the PLL and $V_s$ is the peak amplitude of the fundamental component of the grid voltage. Usually, the $\omega_{BW}$ will be limited by either the sampling frequency in the case of a digital implementation or by the harmonic distortion contained in $v_s$, that is, the $\omega_{BW}$ is bounded from above to allow enough rejection of the harmonic distortion.

The above embodiment has been tested numerically under conditions of a highly distorted signal and under frequency variations. The grid voltage signal is considered as being composed by a fundamental component which is distorted by the 3rd, 5th and 7th harmonics, whose amplitudes and phase shift values are given in Table 1.

Table 1. Amplitudes and phases of the harmonic components of the grid voltage.

| No. Harmonic | Amplitude ($V_{RMS}$) | Phase Shift [deg] |
|---|---|---|
| 1 | 230 | 0 |
| 3 | 50 | 14.3 |
| 5 | 25 | 8.6 |

(continued)

| No. Harmonic | Amplitude (V$_{RMS}$) | Phase Shift [deg] |
|---|---|---|
| 7 | 15 | 5.7 |

Figure 5 shows that for a distorted grid voltage signal, the AQSG-PLL generates an almost sinusoidal signal, which gets very close to the real fundamental component of the grid voltage (dotted line). In this case, a relatively small $\omega_{BW}$ for the PLL has been chosen to reduce the effect of the harmonic disturbance as much as possible. This yields relatively small values for gains $\gamma_1$ and $\lambda$. However, a slight deformation is still present in the fundamental component estimate $\hat{v}_{s,1}$, and thus for more distorted grid voltage signals, an additional harmonic compensation mechanism should be included.

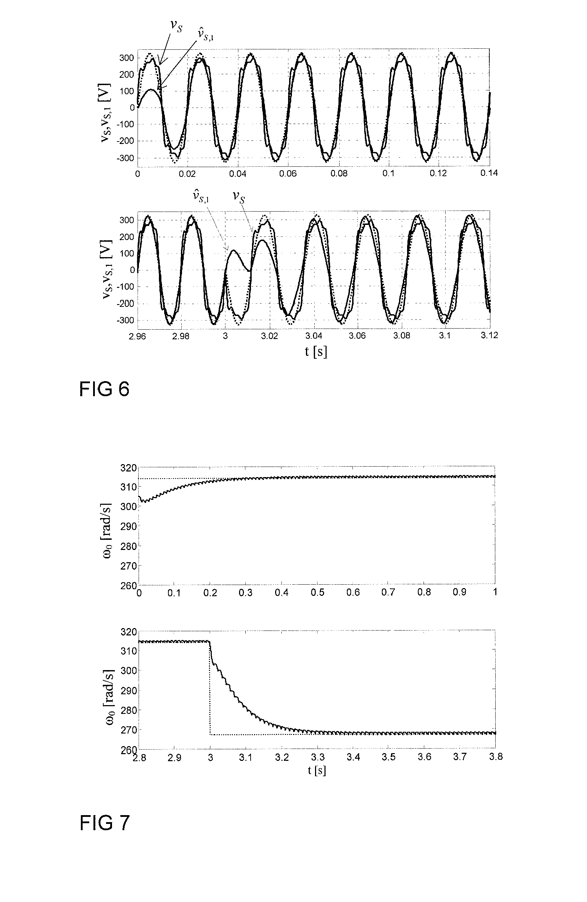

Figure 6 shows (in the top plot) a transient during the start-up operation. In this case it can be observed that the estimated fundamental component signal reaches the steady state after approximately a cycle and a half. Then, (in the bottom plot) it can be observed that, after a step change in the fundamental frequency of the grid voltage, the estimated component reaches the expected value after two cycles. In the frequency change, the frequency changes from 314.16 r/s (50 Hz) to 267.03 r/s (42.5 Hz).

Figure 7 shows the transients of the estimated fundamental frequency during the start-up operation (in the top plot), and during the step change of the fundamental frequency in the grid voltage (in the bottom plot). It can be observed in both cases that, after a relatively short transient, the estimated frequency reaches the expected value on average. The frequency step change is from 314.16 r/s (50 Hz) to 267.03 r/s (42.5 Hz).

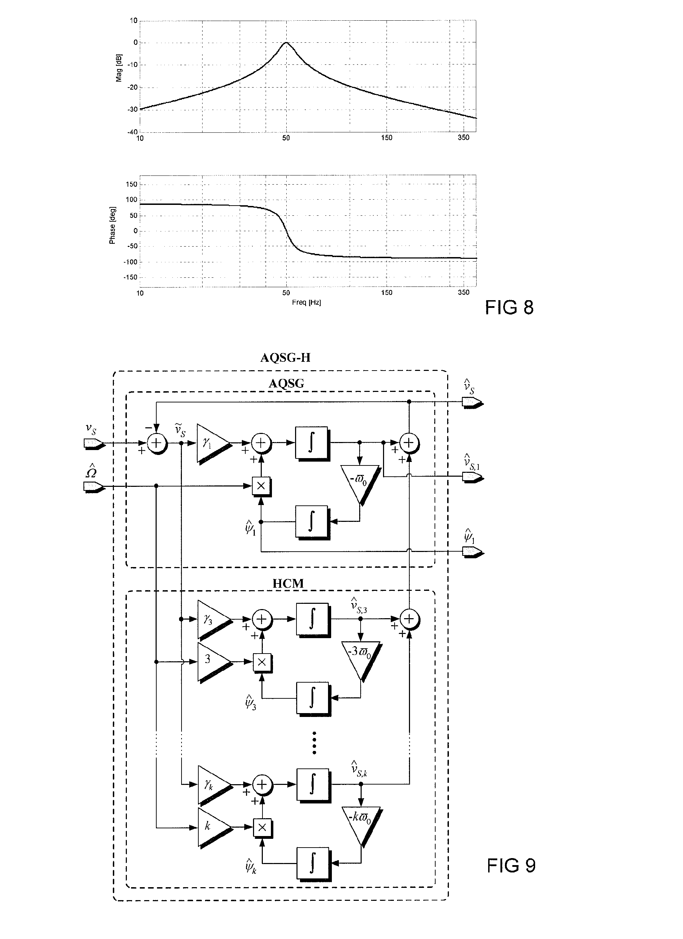

Assuming that the estimated frequency has reached the expected constant value, i.e. $\hat{\omega}_0 = \omega_0$, then the system becomes linear and we can have a good approximation of its frequency response, which is depicted in Figure 8. In this case, the response corresponds to a band pass filter, where the gain at the fundamental frequency is fixed to 0 dB with a corresponding zero phase shift.

In case of highly distorted grid voltage signals the above embodiment is further modified. For this purpose the following more general model of the generator of the grid voltage signal is considered. Basically, the higher harmonics components of the grid voltage are included as follows:

$$\begin{cases} \dot{v}_{S,1} = \omega_0 \varphi_1 \\ \dot{\varphi}_1 = -\omega_0 v_{S,1} \end{cases}$$

$$\begin{cases} \dot{v}_{S,3} = 3\omega_0 \varphi_3 \\ \dot{\varphi}_3 = -3\omega_0 v_{S,3} \end{cases} \tag{10}$$

$$\vdots$$

$$\begin{cases} \dot{v}_{S,k} = k\omega_0 \varphi_k \\ \dot{\varphi}_k = -k\omega_0 v_{S,k} \end{cases}$$

The sum of all these components conform to the overall grid voltage signal given by

$$v_S = \sum_{k \in \{1,3,\dots\}} v_{S,k} \tag{11}$$

Following similar ideas as in the above AQSG-PLL, the following transformations are carried out:

$$\psi_k = \varpi_0 \frac{\varphi_k}{\omega_0}$$

$$\Omega = \frac{\omega_0^2}{\varpi_0} \tag{12}$$

out of which the model can be rewritten as

$$\begin{cases} \dot{v}_{S,1} = \Omega \psi_1 \\ \dot{\psi}_1 = -\varpi_0 v_{S,1} \end{cases}$$

$$\begin{cases} \dot{v}_{S,3} = 3\Omega \psi_3 \\ \dot{\psi}_1 = -3\varpi_0 v_{S,3} \end{cases}$$

$$\vdots \tag{13}$$

$$\begin{cases} \dot{v}_{S,k} = k\Omega \psi_k \\ \dot{\psi}_k = -k\varpi_0 v_{S,k} \end{cases}$$

$$v_S = \sum_{k \in \{1,3,\dots\}} v_{S,k}$$

On the basis of the structure of the above generic model, an estimator for the fundamental component $v_{s,1}$ of the grid voltage $v_s$, which is referred to as AQSG-H, can be constructed as follows

$$\dot{\hat{v}}_{S,1} = \hat{\Omega} \hat{\psi}_1 + \gamma_1 \widetilde{v}_S$$

$$\dot{\hat{\psi}}_1 = -\varpi_0 \hat{v}_{S,1}$$

$$\dot{\hat{v}}_{S,3} = 3\hat{\Omega} \hat{\psi}_3 + \gamma_3 \widetilde{v}_S$$

$$\dot{\hat{\psi}}_3 = -3\varpi_0 \hat{v}_{S,3} \tag{14}$$

$$\vdots$$

$$\dot{\hat{v}}_{S,k} = k\hat{\Omega} \hat{\psi}_k + \gamma_3 \widetilde{v}_S$$

$$\dot{\hat{\psi}}_k = -k\varpi_0 \hat{v}_{S,k}$$

where $\widetilde{v}_S = v_S - \hat{v}_S$ , and

$$\hat{v}_S = \sum_{k \in \{1,3,\dots\}} \hat{v}_{S,k} \tag{15}$$

This extended AQSG-H can be, in fact, viewed as the composition of the basic AQSG to which a harmonic compensation mechanism (HCM) has been added for the harmonic compensation, as observed in the block diagram presented in Figure 9. In other words, the basic AQSG can be recovered if the HCM is eliminated.

In Figure 9 block AQSG outputs the difference $\tilde{v}_s$ between the measured and estimated grid voltages together with the estimated parameter $\hat{\Omega}$ to the harmonic compensation mechanism HCM. The system for each harmonic component comprises basically same elements as the AQSG. The difference is that the gains used are different and the frequency-dependent parts are multiplied with the number of the harmonic in question. It can be seen in Figure 9 that estimate $\hat{\Omega}$ is multiplied and the nominal value of the fundamental frequency $\varpi_0$ is also multiplied in the feedback loop.

Notice that the AQSG-H estimates every single selected harmonic component of the grid voltage $v_s$ These estimated harmonic components are later lumped together to built an estimate $\hat{v}_s$ of the overall grid voltage signal.

To estimate the fundamental frequency, an adaptive law similar to the previously presented FFE in (7) is formed, that is,

$$\dot{\hat{\Omega}} = \lambda \hat{\psi}_1 \tilde{v}_s$$
$$\hat{\omega}_0 = \sqrt{\varpi_0 \hat{\Omega}}$$

$$(16)$$

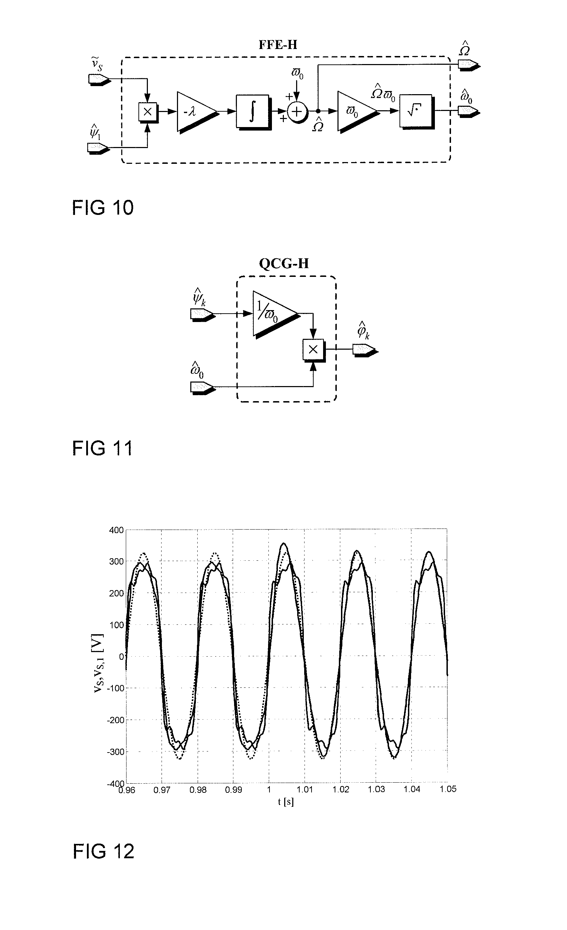

This fundamental frequency estimator is referred to as FFE-H. A block diagram is presented in Figure 10. Notice that this scheme coincides with the previously proposed FFE, except for the new definition of $\hat{v}_s$.

It should be noted that the previously proposed FFE in (7) considered only $\hat{v}_{s,1}$ in the computation of $\tilde{v}_s$ for the estimation of the fundamental frequency. In contrast, the scheme FFE-H (16) considers the overall $\hat{v}_s$, which contains all harmonics contained in the grid voltage $v_s$. Thus in the case of highly distorted grid voltage, it is expected that the estimation of the fundamental frequency will be much cleaner.

If necessary, the fundamental component of the quadrature-companion signal is computed according to

$$\hat{\varphi}_1 = \hat{\omega}_0 \frac{\hat{\psi}_1}{\varpi_0}$$

$$(17)$$

which coincides with (8). In general the k-th harmonic component of the quadrature-companion signal can be obtained as

$$\hat{\varphi}_k = \hat{\omega}_0 \frac{\hat{\psi}_k}{\varpi_0}$$

$$(18)$$

which is represented in Figure 11.

Summarizing, the proposed AQSG-H-PLL consists of the AQSG-H of Figure 9, the FFE-H of Figure 10, and, if required, the QCG-H of Figure 11. Notice that the AQSG-H is composed, in turn, of the AQSG plus the HCM as shown in Figure 9.

It is clear that the computational effort has increased with the consideration of the harmonics compensation mechanism. Therefore, the use of a more complex controller is practical only in cases of extreme harmonic distortion.

The same tests as in the previous scheme AQSG-PLL have been considered here. That is, the grid voltage is perturbed by the 3$^{rd}$, 5$^{th}$ and 7$^{th}$ harmonics.

Figure 12 shows a first test, in which, for comparison purposes, the original AQSG-PLL is first allowed to work up to $t$=1 s. It can be observed that, due to the highly distorted grid voltage, the estimated fundamental component does not reach a perfect sinusoidal shape but a slightly deformed signal still containing some remains of the harmonic distortion. Then, after $t$=1 s the overall AQSG-H-PLL is enabled, i.e. the HCM is enabled for the harmonics compensation. It can thus be observed that, after a relatively short transient of about one cycle and a half, the estimated fundamental component reaches a pure sinusoidal shape, with the same amplitude and frequency as the real fundamental component (in dotted line), despite of the distortion in the grid voltage.

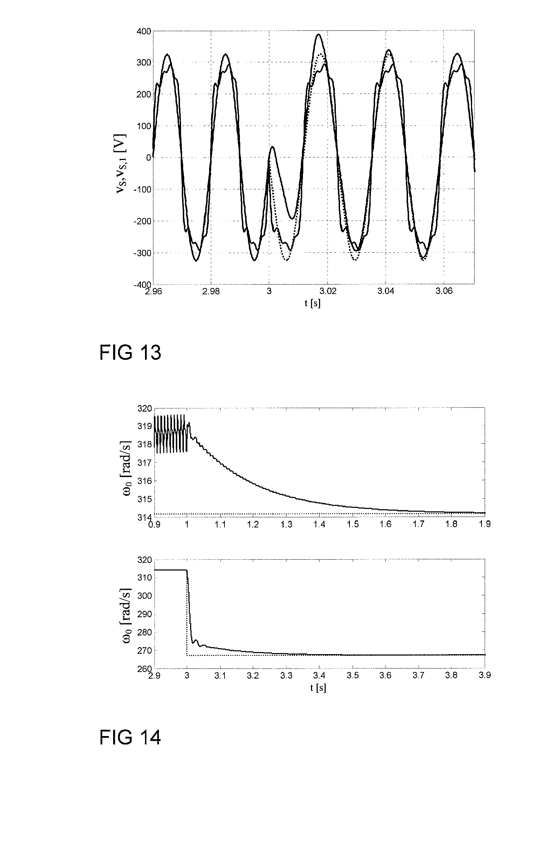

Then, at $t$=3 s a step change in the fundamental frequency of the grid voltage is introduced. Figure 13 shows the transient during such a disturbance. It can be observed that after a relatively short transient of about two cycles, the estimated fundamental component has reached a pure sinusoidal shape with the same amplitude and phase shift as the real fundamental component of the grid voltage (in dotted line) The frequency step change in Figure 13 is from 314.16 r/s (50 Hz) to 267.03 r/s (42.5 Hz)..

Figure 14 shows the transients of the estimated fundamental frequency $\hat{\omega}_0$ when (top plot) the scheme is changed from AQSG-PLL to the AQSG-H-PLL. It can be observed that in cases of high harmonic distortion, the estimation of the fundamental frequency may present a considerable ripple, and also a considerable steady state error if the scheme AQSG-PLL with no harmonic compensation is used. In contrast, it can be observed that after enabling the scheme AQSG-H-PLL at $t$=1 s, the estimate of the fundamental frequency not only gets cleaner but also reaches the expected constant value. In the same figure (bottom plot) the transient is presented during a step change in the fundamental frequency from 314.16 r/s (50 Hz) to 267.03 r/s (42.5 Hz) at $t$=3 s. Notice that after a relatively short transient, the estimated frequency reaches the expected constant value as well.

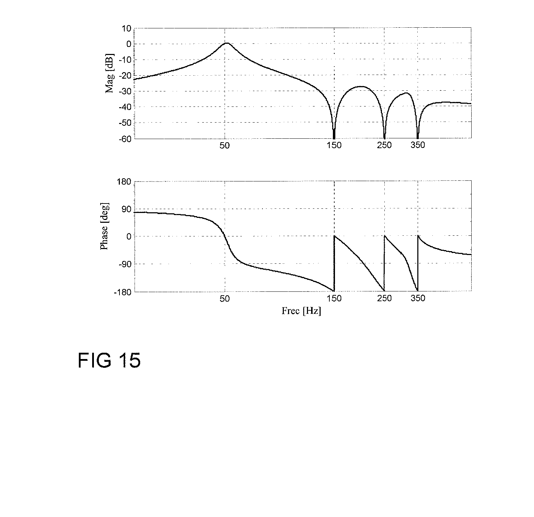

Assuming that the estimate of the fundamental frequency has reached the expected constant value, the system becomes linear and thus the frequency response can be obtained as shown in Figure 15. Notice in this figure that, as a consequence of the introduction of the harmonic compensation mechanism, several zeros have been introduced at the harmonics under concern, which create notches at the corresponding harmonics, in this case the 3rd, 4th and 5th harmonics. This explains the harmonics compensation mechanism of the proposed AQSG-H-PLL for the cancellation of the harmonics under concern.

It will be obvious to a person skilled in the art that, as the technology advances, the inventive concept can be implemented in various ways. The invention and its embodiments are not limited to the examples described above but may vary within the scope of the claims.

References

[1] Hsieh and J.C. Hung, "Phase-locked loop techniques - a survey," IEEE Trans. Ind. Electr., Vol. 43(6), pp. 609-615, 1996.

[2] Kaura and V. Blasco, "Operation of a phase locked loop system under distorted utility conditions," IEEE Trans. Ind. Appl., Vol. 33, pp. 58-63, Jan./Feb. 1997.

[3] L.N. Arruda, S.M. Silva, B.J. Cardoso, "PLL structures for utility connected systems," in Proc. 36th Ind. Appl. Soc. Annual Meet. IAS 01, Vol. 4, USA 2001, pp. 2655-2660.

[4] R.M. Santos, P.F. Seixas, P.C. Cortizo, L.A.B. Torres, and A.F. Souza, "Comparison of three single-phase PLL algorithms for UPS applications," IEEE Trans. Ind. Electr., Vol. 55(8), pp. 2923-2931, August 2008.

[5] S.M. Silva, B.M. Lopes, B.J. Cardoso, R.P. Campana, and W.C. Boaventura, "Performance evaluation pf PLL algorithms for single-phase grid-connected systems," in Proc. IEEE Ind. Appl. Conf. IAS 04, Vol. 4 2004, pp. 2259-2263.

[6] M. Karimi-Ghartemani and M.R. Iravani, "A method for synchronization of power electronic converters in polluted and variable-frequency environments," IEEE Trans. Power Syst., Vol. 19(3), pp. 1263-1270, Aug. 2004.

[7] M. Karimi-Ghartemani and M.R. Iravani, "A new phase-locked loop (PLL) system," in Proc. IEEE MVIISCAS 01, 2001, pp. 421-424.

[8] L.G.B. Rolim et al, "Analysis and software implementation of a robust synchronizing PLL circuit based on the pq theory," IEEE Trans. Ind. Electron., Vol. 53(6), pp. 1919-1926, Dec. 2006.

[9] N. Saitou, M. Matsui, and T. Shimizu, "A control strategy of single -phase active filter under a novel d-q transformation," in Proc. Ind. Appl. Annual Meet. IAS 03, USA, 2003.

[10] A.V. Timbus, R. Teodorescu, M. Liserre, and P. Rodriguez, "PLL algorithm for power generation systems robust to grid voltage faults," in Proc. 37th IEEE Power Electronics Specialists Conference PESC 06, 18-22 June 2006, pp. 1-7.

[11] P. Rodriguez, R. Teodorescu, I. Candela, A.V. Timbus, M. Liserre and F. Blaabjerg, "New positive-sequence voltage detector for grid synchronization of power converters under faulty grid conditions," in Proc. IEEE Power Electronics Specialist Conference PESC 06, July 2006, pp. 1-7.

[12] Patent W02008/055499, "Advanced real-time grid monitoring system," inventors R. Teodorescu, P. Rodriguez, published May 15, 2008.

[13] P. Rodriguez et al, "Advanced grid synchronization system for power converters under unbalance and distorted

## EP 2 354 800 A1

operation conditions," in Proc. 32nd IEEE Industrial Electronics Conference IECON 06, Nov. 2006, pp. 5173-5178.
[14] S.r Sastry and M. Bodson, "Adaptive Control: Stability, Convergence, and Robustness," Prentice-Hall, 1989.

**Claims**

1. A method of estimating the fundamental frequency component of the grid voltage ($\hat{v}_{s,1}$) of a single phase network, **characterized in that** the method comprises the steps of

measuring the grid voltage ($v_s$) of the single phase network, forming an adaptive estimator (AQSG) having a parameter ($\hat{\Omega}$) having the information on the fundamental frequency ($\omega_0$) of the grid voltage, the adaptive estimator producing an estimate of the fundamental frequency component of the grid voltage,

forming an adaptation law (FFE) receiving parameters from the adaptive estimator (AQSG) for producing an estimate for the parameter ($\hat{\Omega}$) having the information on the fundamental frequency of the grid voltage,

feeding the estimated value for the parameter ($\hat{\Omega}$) having the information of the fundamental frequency to the adaptive estimator from the adaptation law to be used in the estimation of the fundamental frequency component of the grid voltage ($\hat{v}_{s,1}$)

2. A method according to claim 1, **characterized in that** the adaptation law (FFE) receives from the adaptive estimator (AQSG) as a parameter an estimate of parameter ($\hat{\psi}_1$) representing the product of the nominal value of the fundamental frequency ($\varpi_0$) and the quadrature companion signal ($\hat{\varphi}_1$) of the grid voltage divided by the estimate of the fundamental frequency of the grid ($\hat{\omega}_0$)

3. A method according to claim 1 or 2, **characterized in that** the adaptation law (FFE) receives from the adaptive estimator (AQSG) as a parameter the difference ($\tilde{v}_s$) between the measured grid voltage ($v_s$) and the estimated fundamental component of the grid voltage ($\hat{v}_{s,1}$).

4. A method according to claim 1 or 2, **characterized in that** the adaptation law (FFE) receives from the adaptive estimator (AQSG) as a parameter the difference ($\hat{v}_s$) between the measured grid voltage ($v_s$) and the estimated grid voltage ($\hat{v}_s$).

5. A method according to any one of claims 1 to 4, **characterized in that** the method comprises a step of

forming a harmonic compensation mechanism (HCM) for estimating the selected harmonic components of the grid voltage by using the difference ($\tilde{v}_s = v_s - \tilde{v}_s$) between the measured grid voltage ($v_s$) and the estimated grid voltage ($\hat{v}_s$) and the parameter ($\hat{\Omega}$) having the information on the fundamental frequency obtained with the adaptive estimator and the adaptation law.

6. A method as claimed in claim 5, **characterized in that** the method comprises the step of forming an estimated grid voltage by adding estimated harmonic components of the grid voltage to the estimated fundamental component of the grid voltage.

7. A method as claimed in any one of the preceding claims, **characterized in that** the parameter ($\hat{\Omega}$) having the information on the fundamental frequency ($\omega_0$) of the grid voltage is a scaled square of the fundamental frequency.

8. A method as claimed in any one of the preceding claims, c h a r a c t e r i z e d in that the method further comprises a step of estimating the quadrature companion signal of the grid voltage.

9. An arrangement for estimating the fundamental frequency component of the grid voltage ($\hat{v}_{s,1}$) of a single phase network, characteri z e d in that the arrangement comprises

means for measuring the grid voltage ($v_s$) of the single phase network,

an adaptive estimator (AQSG) having a parameter ($\hat{\Omega}$) having the information on the fundamental frequency ($\omega_0$) of the grid voltage, the adaptive estimator being adapted to produce an estimate of the fundamental frequency component of the grid voltage,

an adaptation law (FFE) adapted to receive parameters from the adaptive estimator (AQSG) for producing an estimate for the parameter ($\hat{\Omega}$) having the information on the fundamental frequency of the grid voltage, and

**11**

the estimated value for the parameter ($\hat{\Omega}$) having the information on the fundamental frequency is fed to the adaptive estimator from the adaptation law used in the estimation of the fundamental frequency component of the grid voltage ($\hat{v}_{s,1}$).

FIG 1

FIG 2

FIG 3

FIG 4

FIG 5

FIG 6

FIG 7

FIG 8

FIG 9

FIG 10

FIG 11

FIG 12

FIG 13

FIG 14

FIG 15

Europäisches
Patentamt
European
Patent Office
Office européen
des brevets

## EUROPEAN SEARCH REPORT

Application Number

EP 10 15 2247

**DOCUMENTS CONSIDERED TO BE RELEVANT**

| Category | Citation of document with indication, where appropriate, of relevant passages | Relevant to claim | CLASSIFICATION OF THE APPLICATION (IPC) |
|---|---|---|---|
| X | PEDRO RODRIGUEZ ET AL: "Multiple second order generalized integrators for harmonic synchronization of power converters" ENERGY CONVERSION CONGRESS AND EXPOSITION, 2009. ECCE. IEEE, IEEE, PISCATAWAY, NJ, USA, 20 September 2009 (2009-09-20), pages 2239-2246, XP031560857 ISBN: 978-1-4244-2893-9 * abstract; figures 1-5,9 * | 1-9 | INV. G01R19/25 |
| X,D | WO 2008/055499 A2 (AALBORG UNI [DK]; TEODORESCU REMUS [DK]; RODRIGUEZ PEDRO [ES]) 15 May 2008 (2008-05-15) * abstract; figures 1,3-5 * | 1,9 | |
| E | WO 2010/051810 A1 (VESTAS WIND SYS AS [DK]; RODRIGUEZ PEDRO [ES]; TEODORESCU REMUS [DK]) 14 May 2010 (2010-05-14) * abstract; figures 1-3,12-14 * | 1,9 | |
| X | JP 2008 141935 A (C & S KOKUSAI KENKYUSHO KK) 19 June 2008 (2008-06-19) * abstract; figures 1,3-5 * | 1,9 | TECHNICAL FIELDS SEARCHED (IPC) G01R |
| X | KAMWA I ET AL: "On-Line Tracking of Changing Harmonics in Stressed Power Systems: Application to Hydro-Québec Network" IEEE TRANSACTIONS ON POWER DELIVERY, IEEE SERVICE CENTER, NEW YORK, NY, US, vol. 11, no. 4, 1 October 1996 (1996-10-01), pages 2020-2027, XP011049236 ISSN: 0885-8977 * abstract; figure 5 * | 1,9 | |

The present search report has been drawn up for all claims

| Place of search | Date of completion of the search | Examiner |
|---|---|---|
| Berlin | 16 July 2010 | Fritz, Stephan C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 10 15 2247

This annex lists the patent family members relating to the patent documents cited in  the above-mentioned European search report.
The members are as contained in the European Patent Office EDP file on
The European Patent Office is in no way liable for these particulars which are merely given for the purpose of information.

16-07-2010

| Patent document cited in search report | | Publication date | Patent family member(s) | | Publication date |
|---|---|---|---|---|---|
| WO 2008055499 | A2 | 15-05-2008 | CN EP | 101617234 A 2089725 A2 | 30-12-2009 19-08-2009 |
| WO 2010051810 | A1 | 14-05-2010 | NONE | | |
| JP 2008141935 | A | 19-06-2008 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2008055499 A

### Non-patent literature cited in the description

- **HSIEH ; J.C. HUNG.** Phase-locked loop techniques - a survey. *IEEE Trans. Ind. Electr.,* 1996, vol. 43 (6), 609-615
- **KAURA ; V. BLASCO.** Operation of a phase locked loop system under distorted utility conditions. *IEEE Trans. Ind. Appl.,* January 1997, vol. 33, 58-63
- **L.N. ARRUDA ; S.M. SILVA ; B.J. CARDOSO.** PLL structures for utility connected systems. *Proc. 36th Ind. Appl. Soc. Annual Meet. IAS 01,* 2001, vol. 4, 2655-2660
- **R.M. SANTOS ; P.F. SEIXAS ; P.C. CORTIZO ; L.A.B. TORRES ; A.F. SOUZA.** Comparison of three single-phase PLL algorithms for UPS applications. *IEEE Trans. Ind. Electr.,* August 2008, vol. 55 (8), 2923-2931
- **S.M. SILVA ; B.M. LOPES ; B.J. CARDOSO ; R.P. CAMPANA ; W.C. BOAVENTURA.** Performance evaluation pf PLL algorithms for single-phase grid-connected systems. *Proc. IEEE Ind. Appl. Conf. IAS 04,* 2004, vol. 4, 2259-2263
- **M. KARIMI-GHARTEMANI ; M.R. LRAVANI.** A method for synchronization of power electronic converters in polluted and variable-frequency environments. *IEEE Trans. Power Syst.,* August 2004, vol. 19 (3), 1263-1270
- **M. KARIMI-GHARTEMANI ; M.R. IRAVANI.** A new phase-locked loop (PLL) system. *Proc. IEEE MVIIS-CAS 01,* 2001, 421-424
- **L.G.B. ROLIM et al.** Analysis and software implementation of a robust synchronizing PLL circuit based on the pq theory. *IEEE Trans. Ind. Electron.,* December 2006, vol. 53 (6), 1919-1926
- **N. SAITOU ; M. MATSUI ; T. SHIMIZU.** A control strategy of single -phase active filter under a novel d-q transformation. *Proc. Ind. Appl. Annual Meet. IAS 03, USA,* 2003
- **A.V. TIMBUS ; R. TEODORESCU ; M. LISERRE ; P. RODRIGUEZ.** PLL algorithm for power generation systems robust to grid voltage faults. *Proc. 37th IEEE Power Electronics Specialists Conference PESC 06,* 18 June 2006, 1-7
- **P. RODRIGUEZ ; R. TEODORESCU ; L. CANDELA ; A.V. TIMBUS ; M. LISERRE ; F. BLAABJERG.** New positive-sequence voltage detector for grid synchronization of power converters under faulty grid conditions. *Proc. IEEE Power Electronics Specialist Conference PESC 06,* July 2006, 1-7
- **P. RODRIGUEZ et al.** Advanced grid synchronization system for power converters under unbalance and distorted operation conditions. *Proc. 32nd IEEE Industrial Electronics Conference IECON 06,* November 2006, 5173-5178
- **S.R SASTRY ; M. BODSON.** Adaptive Control: Stability, Convergence, and Robustness. 1989